# EUROPEAN PATENT APPLICATION

(11) **EP 4 807 992 A1**
(43) Date of publication of application: **16.09.2026**
(21) Application number: 26163542.9
(22) Date of filing: 10.03.2026
(51) Int. Cl.: H03K 17/16

(54) **SYSTEMS AND METHODS FOR DI/DT CONTROL OF SOLID STATE POWER CONTROLLERS**

(30) Priority: 12.03.2025 US 202519077963
(71) Applicant: GE Aviation Systems Limited, Bishops Cleeve Cheltenham Gloucestershire GL52 8SF (GB)
(72) Inventor: HANDY, Peter James, Cheltenham, GL52 8SF (GB); GLENNY, Michael, Cheltenham, GL52 8SF (GB); COLLINS, John Oliver, Cheltenham, GL52 8SF (GB); ROPER, Simon Edward, Cheltenham, GL52 8SF (GB)
(74) Representative: Openshaw & Co.

(57) **Abstract**

There are provided systems and methods for controlling input current to one or more solid state power controllers. The system may include: a solid state power controller (302) including a switching component (306) and configured for a current input and a current output; a current limiting control circuit (308) of the solid state power controller (302) regulating and limiting input current to the switching component (306); and a dl/dt generator (304) operatively coupled to the current limiting control circuit (308), the dl/dt generator (304) being adjustable to set a current limit setpoint to regulate an amount of input current being supplied to the switching component (306) to a predetermined increasing or decreasing profile for a predetermined time period.

## Description

### TECHNICAL FIELD

These teachings relate generally to electrical power distribution systems, and specifically to dI/dt control of solid state power controllers in electrical power distribution systems.

### BACKGROUND

Power distribution units are used in various contexts to distribute electrical power to multiple separate systems. In certain contexts, these power distribution units may include solid state power controllers (SSPCs) that operate as switches to distribute power from a power source to designated loads. For example, SSPCs are often used in airplane applications, which have systems that may utilize high voltages, high currents, and/or reliable switching.

The rate of change of current can fluctuate significantly in SSPCs, such as, for example, when an SSPC is turned on or off. It is desirable to control this rate of change of current, i.e., to regulate the rate of change of current with respect to time (dl/dt) in electrical circuits. This control can minimize or limit the effects of rapid current fluctuations, which can lead to issues such as electromagnetic interference, voltage spikes, current overshoot, and potentially interoperability issues, such as unwanted interactions between various loads on the power network. It is desirable to regulate the rate of current change to help enhance the stability and reliability of power distribution systems in various load types.

### BRIEF DESCRIPTION OF DRAWINGS

Various needs are at least partially met through provision of dI/dt control of SSPCs, as described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 is a schematic view of an electrical power distribution system in accordance with various embodiments;
FIG. 2 is a circuit diagram showing a portion of a prior art SSPC;
FIG. 3 is a circuit diagram showing a dl/dt generator and SSPC in accordance with various embodiments;
FIG. 4 is a circuit diagram showing a dI/dt generator and SSPC in accordance with various embodiments;
FIG. 5 is a circuit diagram showing a dl/dt generator and SSPC in accordance with various embodiments;
FIG. 6 is a circuit diagram showing a dl/dt generator and SSPC in accordance with various embodiments;
FIG. 7 shows a graph combining output voltage, input voltage, and output current with no dl/dt control in accordance with various embodiments;
FIG. 8 shows a graph combining output voltage, input voltage, and input current with dI/dt control in accordance with various embodiments; and
FIG. 9 is a flow diagram of a process in accordance with various embodiments.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

The following embodiments illustrate approaches for the dl/dt control of SSPCs in power distribution units. For example, in the aviation context, modern aviation power systems use SSPCs that may experience fluctuations in current in various circumstances. In one form, SSPCs may be used to dynamically switch loads on and off during a flight profile. The load and wiring within such power distribution system have inductive and capacitive elements. The effect of switching into these complex loads can cause the input voltage to fluctuate or sag with significant spikes, impacting power quality, which in turn can disrupt other loads in the system. When an aviation system integrates a large number of complex loads into a power distribution system utilizing SSPCs, this integration can cause interoperability issues, and in the extreme, may cause loads to malfunction.

This disclosure addresses a system that enables or disables the dl/dt function per switched output, allowing the power quality to be managed and optimized for specific load characteristics. Although this disclosure addresses current fluctuation when the SSPC is turned on, it should be understood that the dI/dt function may be used in any circumstance to control the rate of change of current. More specifically, it may be used to set a predetermined increasing or decreasing current profile.

In one form, a dl/dt generator (or dl/dt limiter) may use a sliding closed-loop current limit to control the rate of change of current when an SSPC is turned on into a load. This dl/dt control improves power quality by greatly reducing the voltage transients that would otherwise occur on the power input feeder when SSPCs turn on into loads with high inrush currents. The dl/dt generator may be configurable e.g., it can be enabled or disabled per switched output, depending on the inrush of the connected load. This configurability eases the integration of complex loads into a power system, such as, for example, an aircraft power system, eliminating the switching effect of one output affecting other loads within the power network.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise. Reference throughout this specification to "one embodiment," "an embodiment," "some embodiments", "one form," "a form," "some forms", "an implementation", "some implementations", "some applications", or similar language means that a particular feature, structure, or characteristic described in connection with the embodiment is included in at least one embodiment of the disclosure. It does not mean that the particular feature, structure, or characteristic is required in all embodiments of this disclosure.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

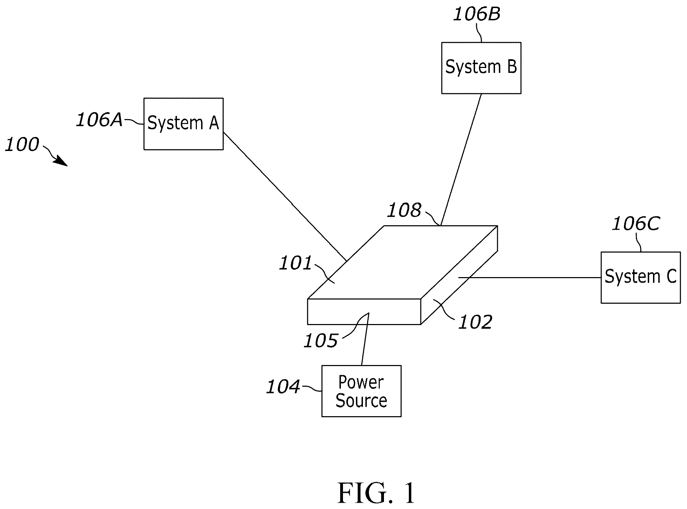

The foregoing and other benefits may become clearer upon making a thorough review and study of the following detailed description. FIG. 1 shows a power distribution unit 101 containing SSPCs that is part of an electrical distribution system 100. Electrical distribution systems 100, such as in aircraft, may use power from one or more sources and distribute power to one or more loads. Power sources may be primary sources, such as, for example, batteries or power cells, or may be outputs of other parts of the overall system. Loads mays utilize power or may be an intermediate stage in the overall system.

In some embodiments, the power distribution unit 101 is in the form of an enclosed module 102 that houses SSPCs therein. The power distribution unit 101 may be coupled to a power source 104 via a power input interface 105. The module 102 may also be coupled to, and distribute power to, multiple systems, or loads 106, such as System A, System B, and System C, via multiple power output interfaces 108. In other words, the power distribution unit 101 may be operatively coupled to the power source 104 and the plurality of loads 106A, 106B, and 106C. It should be understood that the electrical distribution system 100 is shown at a schematic level and may include other aspects and components that are not necessary for an understanding of this subject matter.

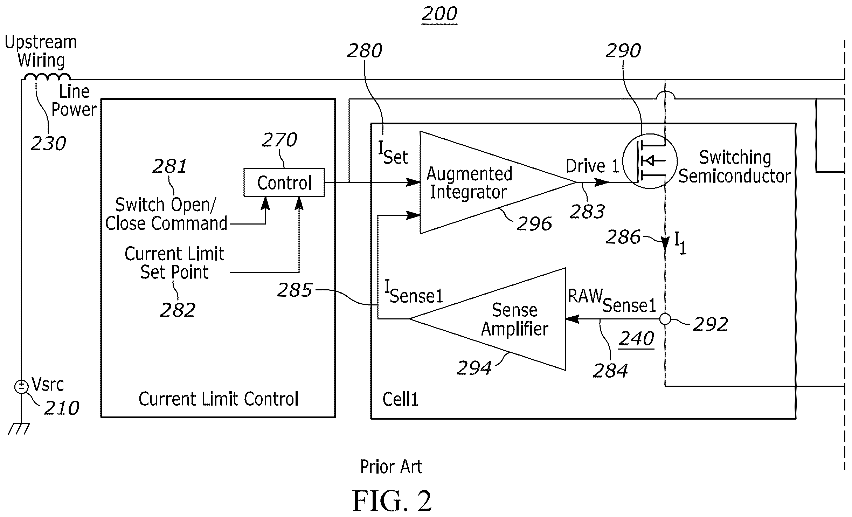

FIG. 2 shows a portion of a prior art SSPC 200. SSPC 200 is an example of an SSPC disposed between a voltage source 210 and a load (not shown). On the upstream side of the SSPC 200, there is upstream wiring 230 between the voltage source 210 and the SSPC 200. This SSPC includes a current cell 240 connected to a current limit controller 270, which provides a current setting signal 280.

In this form, the current setting signal 280 is generated by the current limit controller 270 based on a switch open/close command 281 and a current limit set point signal 282. When the switch open/close command 281 indicates that the switching semiconductor 290 is delivering current, the current limit set point signal 282 is passed to the current cell 240. When the switch open/close command 281 indicates that the switching semiconductor 290 is not supplying current, the current limit set point signal 282 is pulled to ground level.

In this form, the current cell 240 achieves closed loop control that adjusts current that flows through it. FIG. 2 shows the following closed loop: current cell 240 has a switching semiconductor 290 connected to a current level sensor 292; current level sensor 292 is connected to a sense amplifier 294; sense amplifier 294 is connected to an augmented integrator 296; and augmented integrator 296 is connected to switching semiconductor 290 in a closed loop.

In this form, closed loop control is achieved by adjusting the drive current 283 to the switching semiconductor 290 in current cell 240 based on the magnitude of a cell current 286 passing through the current cell 240. To do this, the cell current 286 is measured by the current level sensor 292. The raw sensed current signal 284 output from the current level sensor 292 is typically small and thus amplified using the sense amplifier 294 to generate the sensed current (or current level) signal 285. This sensed current signal 285 is then passed to the augmented integrators 296 for comparison to the value of the current setting signal 280.

The drive current 283 output from the augmented integrator 296 is determined by the difference between the sensed current signal 285 and the current setting signal 280. Current cell 240 controls the drive current 283 passing through it independently based on the difference between the current setting signal 280 and the current signal 285. Such a configuration allows the SSPC 200 to equalize the current being passed through the current cell 240 to reduce the power being dissipated across the switching semiconductor 290, regardless of the power characteristics, such as rated current or on resistance, of the switching semiconductor 290. Although this approach has been described generally in the context of an SSPC with a single current cell 240, it should be understood that it may also be applied to an SSPC with multiple current cells.

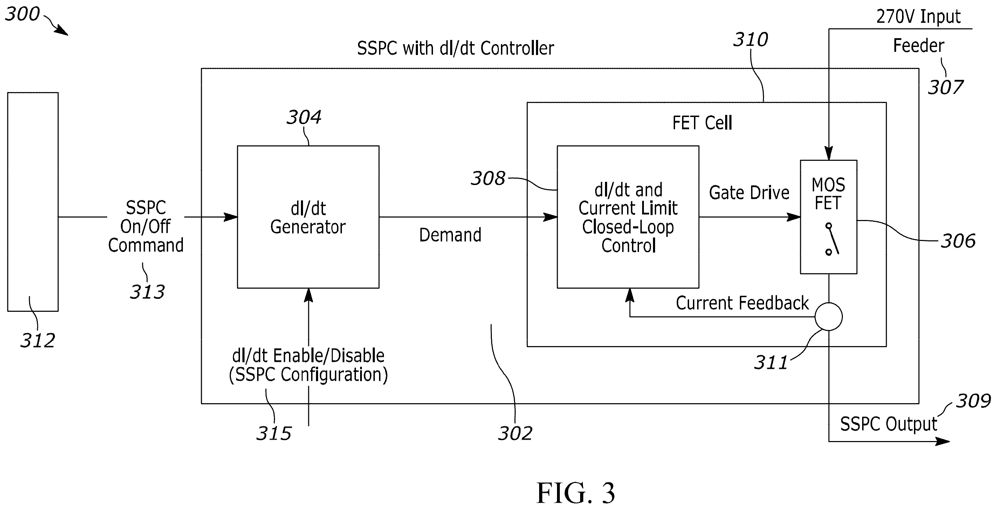

FIG. 3 shows an example of a system 300 utilizing an SSPC 302 with a dI/dt generator 304. In one form, dl/dt control may be achieved at turn on using a closed-loop sliding current limit that is steadily increased over a fixed time interval, from zero to a predetermined limit. This approach limits the rate of current growth (or slew rate) in a precise manner, in order to reduce the input voltage dips or spikes that arise due to upstream inductance, as indicated by the following equation: V_SPIKE = L_UPSTREAM x dI/dt. In this equation, V_SPIKE is a voltage spike, L_UPSTREAM is the wire inductance of the power input feeder between the SSPC and the power source, and dl/dt is the rate of change of current over time.

It is generally contemplated that the dl/dt control may be enabled under various conditions to establish an increasing or decreasing current profile. In one form, it may be used when the SSPC is turned on to create a gradually increasing current profile. When switched on, and with the dl/dt control disabled, the SSPC may experience initial transients and voltage spikes for a short period of time. This fluctuation may potentially ripple through the system and affect other loads. In contrast, when the dI/dt control is enabled, the voltage spikes are reduced or removed.

FIG. 3 shows one form of a system 300 for controlling input current to an SSPC 302. The system 300 includes an SSPC 302 having a switching component 306 and configured for a current input and a current output. It also includes a current limiting control circuit 308 that regulates and limits input current to the switching component 306. Further, the system 300 includes a dl/dt generator 304 that is operatively coupled to the current limiting control circuit 308. The dl/dt generator 304 is adjustable to regulate an amount of input current being supplied to the switching component 306 to a predetermined increasing or decreasing profile. In one form, the SSPC 302 may have a 270V input feeder 307 and an output 309.

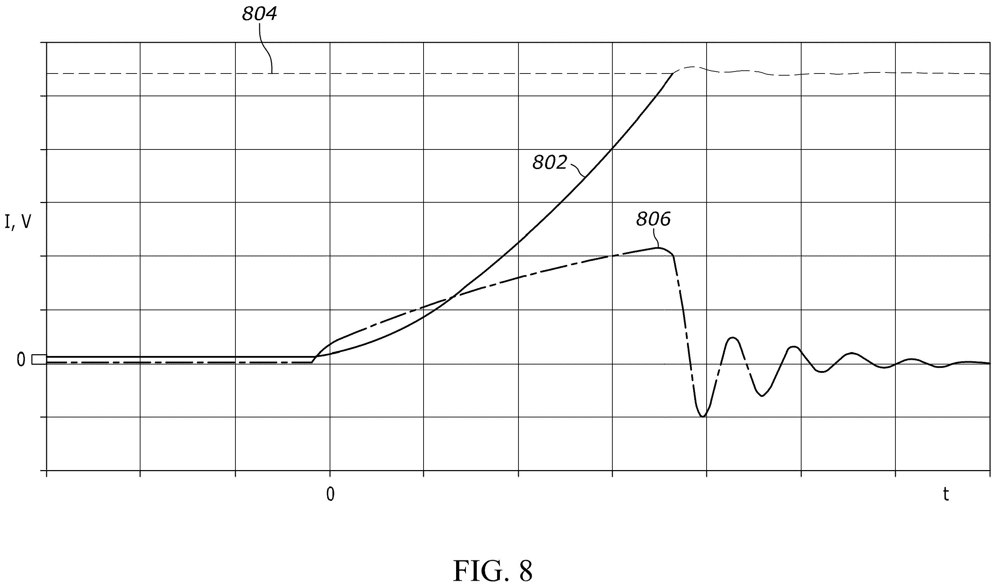

In one form, the dl/dt generator 304 may provide a current turn on profile. For example, the dl/dt generator 304 may be adjustable to regulate the amount of input current being supplied to the switching component 306 to a constantly increasing rate. The dl/dt generator 304 may be adjustable between a first, low level setting allowing a low constant rate of increase in input current and a second, high level setting allowing a high rate of increase in input current. For example, in some circumstances, the dl/dt generator may be set to the first, low level to gradually increase the input current over time. In the context of a constant increase (or ramp) of current (such as shown in FIG. 8), the slope of the ramp may be small, such as for a gradual turn on profile. In other circumstances, the dl/dt generator may be set to the second, high level setting to more rapidly increase the input current over time. In the context of a constant increase of current, the slope of the ramp is greater, such as for a faster turn on profile. In some forms, these two settings may correspond to enable/disable, or ON/OFF, settings for the dl/dt generator 304, as addressed below.

It is also contemplated that the dl/dt generator 304 may provide other current profiles than a constant ramp of increasing current. For example, the dI/dt generator 304 may provide stepwise change of current. As another example, the dl/dt generator 304 may provide a current turn off profile. In other words, the dl/dt generator 304 may be adjustable to regulate the amount of input current being supplied to the switching component 306 to a constantly decreasing rate. The dl/dt generator 304 may be adjustable between a third, low level setting allowing a low constant rate of decrease in input current and a fourth, high level setting allowing a high rate of decrease in input current. The dl/dt generator 304 may provide a decreasing ramp of current over time at the third, low level setting with the switching component 306 being turned off at a controlled and constant rate over time. In one form, this decreasing ramp has a negative constant slope of current over time, which may allow current to be reduced without spikes and other fluctuations. Further, the current limiting control circuit 308 may use closed-loop feedback regarding the current to control the change in current and conform it to the predetermined profile. In some forms, it is contemplated may be adjustable to set different current profiles under different circumstances, such as, for example to set increasing current profiles in certain circumstances and decreasing current profiles in other circumstances.

In this form, the SSPC 302 may include the dl/dt generator 304 and a current cell 310, which includes the switching component 306 and the current limiting control circuit 308. It should be understood that, however, that the dI/dt generator 304 may be separate from the SSPC 302. In other words, in other forms, the dl/dt generator 304 may be separate from, but operatively coupled to, the SSPC 302.

In one form, the increasing or decreasing current profile may be combined with a closed-loop sliding current limit that is steadily increased or decreased over a fixed time interval. For example, for turn on, it may be increased from zero to a predetermined limit. The dl/dt generator 304 may be used to set a gradually increasing setpoint or current limit, and closed loop current feedback may help ensure a smooth current increase close to that setpoint.

Accordingly, in one form, the system 300 provides closed-loop current feedback. The current limiting control circuit 308 may be operatively coupled to the switching component 306 and configured to receive closed-loop current feedback from the switching component 306 to compare to an input current signal. The current limiting control circuit 308 receives current feedback from the switching component 306 and adjusts the current accordingly.

In one form, the system 300 combines the dl/dt generator 304 that regulates input current with the current limiting control circuit 308 that provides closed-loop current feedback. It is contemplated that the combination of these two features may provide advantageous control over the current characteristics as the input current is changed. The dl/dt generator 304 modifies the amount of input current over time in accordance with the predetermined increasing or decreasing profile, such as, for example, to an increasing ramp of current. In combination, the current limiting control circuit 308 uses feedback regarding the current that may smooth out deviations of the input current to conform it to the predetermined profile.

In one form, it is contemplated that the switching component 306 may include (but is not limited to) a transistor. For turn on, for example, the dl/dt generator 304 may provide a ramp of current over time at the first, low level setting with the transistor being turned on at a controlled and constant rate over time. Further, the current limiting control circuit 308 may be operatively coupled to a gate or base of the transistor and to an output of the transistor with the current limiting control circuit 308 configured to receive current feedback from the transistor.

In this form, any of various types of transistors may be used. In one form, it is contemplated that a field effect transistor (FET) may be used, and, in particular, a metal-oxide semiconductor field-effect transistor (MOSFET). However, it should be understood that any of various types of transistors may be used, such as, for example, without limitation, bipolar junction transistors (BJTs), junction field effect transistors (JFETs), insulated gate bipolar transistors (IGBTs), etc.

In one form, it is contemplated that the current limiting control circuit 308 includes a current level sensor 311. The current limiting control circuit 308 may include a current level sensor 311 at an output of the switching component 306 to allow comparison of an input current signal from the dl/dt generator 304 to a current signal from the output of the switching component 306. It is also contemplated that the current limiting control circuit 308 may also include other components to regulate current and facilitate current feedback, such as, for example, controllers, augmented integrators, and/or sense amplifiers.

The system 300 may also include a microcontroller 312. The terms microcontroller, controller, integrated circuit (such as a field-programmable gate array) (FGPA), microprocessor, and processor are generally used interchangeably to refer to any processor-based device, and any such devices may be used interchangeably herein. These terms generally refer to any processor-based device with processor, memory, and programmable input/output peripherals, alone or in combination, which is generally designed to govern the operation of other components and devices. These architectural options should generally be understood. Processors may be configured (for example, by using corresponding programming, instructions, and algorithms stored in a memory as will be well understood by those skilled in the art) to conduct one or more of the steps, actions, and/or functions described herein.

The microcontroller 312 may be operatively coupled to the dl/dt generator 304. This microcontroller 312 may be configured to transmit an SSPC on/off command 313 and/or a dl/dt enable/disable signal 315. Alternatively, multiple microcontrollers may transmit separate signals. In some forms, a configuration table for a microcontroller 312 controlling the SSPC 302 may include an enable/disable setting for the dl/dt generator 304, as addressed below. Further, although the microcontroller 312 is shown as separate from SSPC 302 in FIG. 3, in some forms, it may constitute part of SSPC 302.

The dl/dt generator 304 may be in various forms and may include various settings. In one form, the dl/dt generator 304 may have two settings, i.e. an enable setting and a disable setting (or ON/OFF). In the enable setting, the a dl/dt generator 304 may be at the low level setting and may limit the amount of input current being supplied to the switching component 306 to a constantly increasing rate, e.g., a gradually increasing ramp of current. In the disable setting, the a dl/dt generator 304 may be at the high level setting, which may generally correspond to an uncontrolled input current rate to the SSPC 302 that would occur without the presence of the dl/dt generator 304 in the system 300. In addition, or as an alternative, the dl/dt generator 304 may have settings corresponding to a decreasing current rate.

Further, in some forms, it is contemplated that the dl/dt generator 304 may have a number of intermediate settings between these low and high level settings. The dl/dt generator 304 may be further adjustable to multiple settings of input current rates between the first, low level setting and the second, high level setting where the rate of change of input current is adjusted to different rates. For example, the rate of change may be adjusted across various settings from a slow, gradual increase in current to a faster, less gradual increase in current. In addition, or as an alternative, the rate of change may be adjustable across various settings for a decreasing current rate.

Accordingly, in one form, this dl/dt control approach creates a ramp over a defined duration to the current cell 310. In turn, in this example, the current limiting control circuit 308 creates a gate drive signal for the switching component 306 (power-switching MOSFET). The current cell 310 includes closed-loop control of the current using feedback from a current level sensor 311, and the current limit is steadily increased to a predetermined limit. The MOSFET is turned on slowly and current growth is controlled by a closed-loop in a well-defined manner, rather than instantaneously or more slowly open-loop with an ill-defined rate of current growth that is likely to be affected by individual MOSFET characteristics and external factors such as supply voltage, in-line impedances and load inrush characteristics. In addition, or as an alternative, this approach may also be used generally with a decreasing current profile to control turn off.

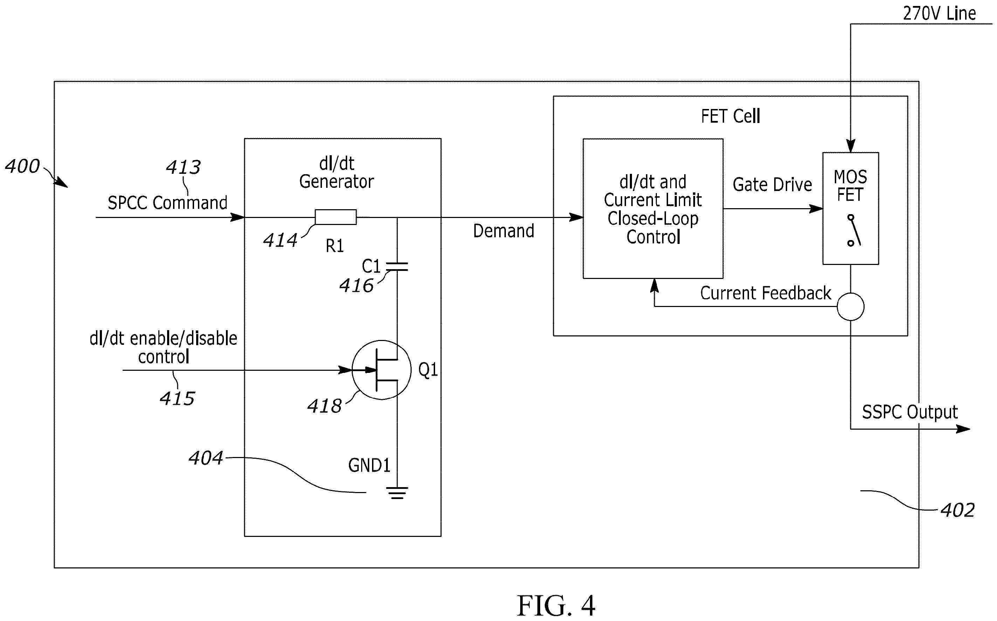

FIG. 4 shows a system 400 with an example of an SSPC 402 including a dl/dt generator 404. The SSPC 402 receives an SSPC on/off command signal 413 and a dl/dt enable/disable control signal 415. In one form, dl/dt generator 404 may include one or more capacitors and one or more resistors that define a radio control (RC) circuit. FIG. 4 shows an RC circuit with resistor R1 (414), capacitor C1 (416), and transistor Q1 (418). The transistor Q1 (418) may be used to enable or disable the dl/dt generator 404, or if used in linear mode, it may be used to provide a variable or configurable dl/dt rate. As will be understood, the values of these components may be selected to achieve a particular rate of current change of the dl/dt generator 404. Further, variable resistors and/or variable capacitors may be used so as to adjust the rate of current change. Also, additional resistors, capacitors, and/or transistors may be added to the circuit to achieve a particular rate of current change.

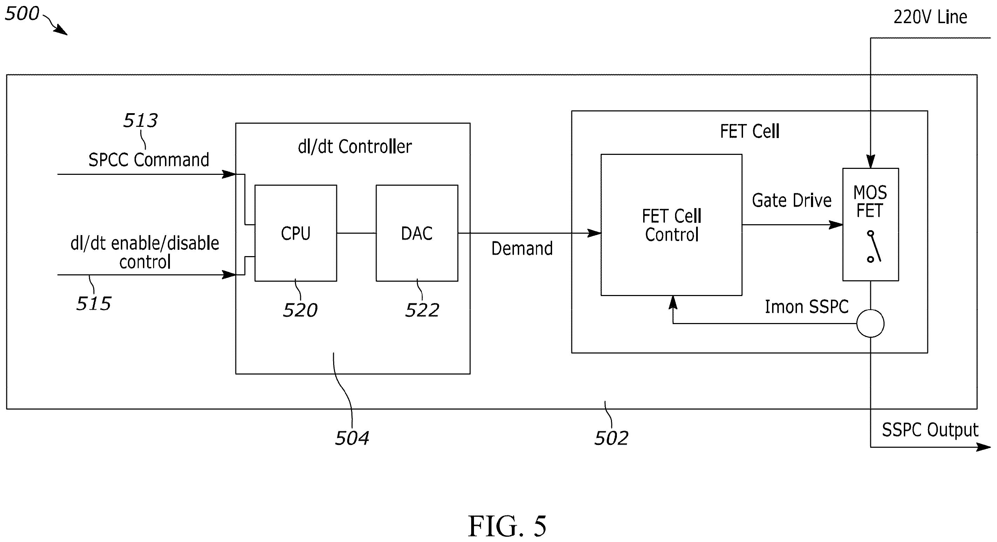

In other forms, the dl/dt generator may include a digital analog converter driven by a microprocessor to generate the ramp profile. As shown in system 500 in FIG. 5, SSPC 502 with an alternative dI/dt generator 504 uses a microcontroller 520 to communicate with a digital to analog converter (DAC) 522, which generates the increasing or decreasing current profile. The microcontroller 520 receives an SSPC command signal 513 and an enable/disable control signal 515. One advantage to the dl/dt generator 504 is that the current profile could be more configurable. In some forms, it may generate the profile as a linear ramp, but it may also generate other arbitrary current profiles, rather than a linear ramp. The profile may be generated at either or both SSPC turn on and turn off, improving the power quality in both scenarios. FIG. 5 shows a microcontroller 520 in combination with an external DAC 522.

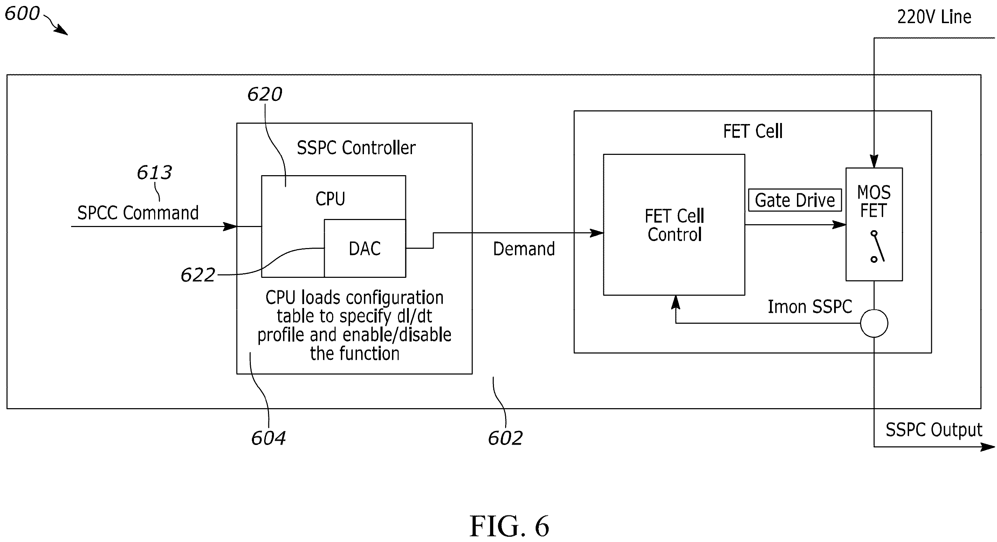

FIG. 6 shows a variation of the approach shown in FIG. 5 using an internal DAC. FIG. 6 shows a system 600 with an SSPC 602 having a dl/dt generator 604 in the form of a microcontroller 620 in combination with an internal DAC 622. The microcontroller 620 receives an SSPC command signal 613 but need not receive an enable/disable control signal. In this form, it is contemplated that the microcontroller 620 may load a configuration table specifying the dl/dt current profile and enabling/disabling the dl/dt function. Thus, in some forms, it is possible to use either an internal or external DAC, and the enabling or disabling of the dl/dt function may either be via a discrete input, as per the RC circuit example above, or by a data bus or by a configuration table loaded into the microcontroller 620.

In one form, it is contemplated that multiple SSPCs 302 with dl/dt generators 304 may be incorporated into a power distribution unit 101. Each SSPC 302 includes a switching component 306 and configured for a current input and a current output. At least one SSPC 302 may include a current limiting control circuit 308 regulating and limiting input current to a corresponding switching component 306. Further, a dI/dt generator 304 may be operatively coupled to this current limiting control circuit 308. It is generally contemplated that the multiple SSPCs 302 may be used in combination with one or more dl/dt generators 304, which may be enabled or disabled depending on the load characteristics of particular SSPCs 302. In one form, multiple SSPCs 302 may be coupled to a single dl/dt generator 304. In one form, a system configurator may enable or disable the dI/dt function per switched output, such as, for example, in the case of SSPCs 302 coupled in parallel to a single switched output, allowing the power quality to be managed and optimized for the specific load characteristics of SSPCs 302.

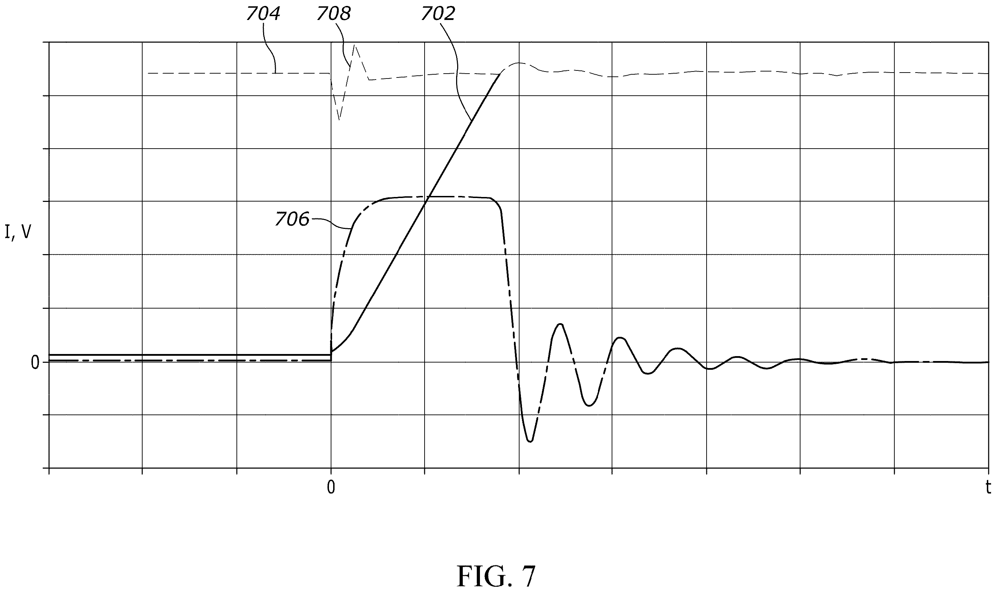

FIG. 7 shows a graph of current and voltage (I, V) over time (t). The graph combines output voltage 702, input voltage 704, and output current 706 for a capacitive load without dl/dt control. In other words, the dl/dt control has been disabled. At time t=0, the SSPC is closed, and for a short time after t=0, there is a voltage spike 708, or distortion, of the input voltage 704. This voltage spike 708 is generally caused by the rapid increase in dl/dt and upstream inductance. Also, at t=0, the output current 706 can be seen to increase rapidly (in an uncontrolled manner) until it reaches a current limit. Further, at t=0, the output voltage 702 increases rapidly until the load capacitor is charged. Around the time the load capacitor is charged, the output current 706 decreases back to 0 over time.

FIG. 8 shows a graph combining output voltage 802, input voltage 804, and output current 806 for a capacitive load with dl/dt control. In other words, the dl/dt control has been enabled. In this example, the load is purely capacitive at turn on (time t=0), as may be the case for some applications. At time t=0, the input voltage spike, or distortion, has been significantly reduced or eliminated. Also, at t=0, the output current rate has been reduced, and the output current 806 can be seen to increase in a more gradual and controlled manner than the output current 706 in FIG. 7. In this example, the output current 806 does not reach the current limit. Further, at t=0, the output voltage 802 increases in a more gradual and controlled manner (relative to the output voltage 702 in FIG. 7) until the load capacitor is charged. Around the time the load capacitor is charged, the output current 806 decreases back to 0 over time.

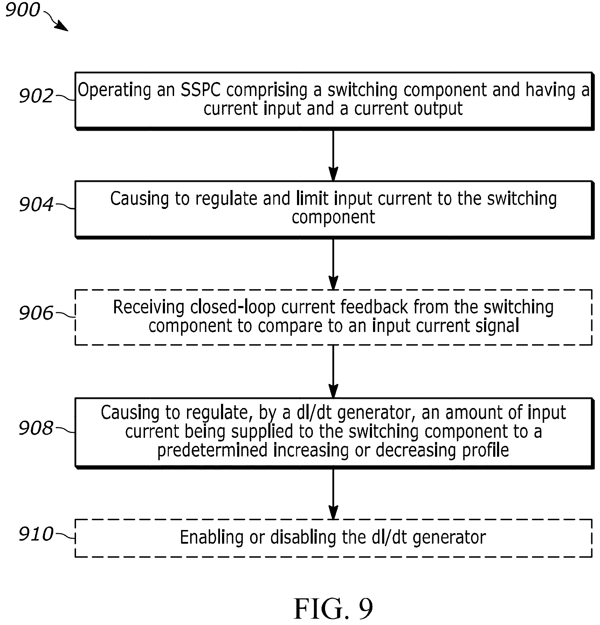

FIG. 9 is a flow diagram of a process 900 for controlling input current to one or more SSPCs. In one form, it is contemplated that the SSPCs are used at a high current, high voltage setting, requiring reliable switching, such as, for example, an airplane application. The process 900 may use some or all of the components described above in connection with systems 100, 300, 400. The above description of these systems is incorporated herein.

At block 902, an SSPC is operated comprising a switching component and having a current input and a current output. In one form, multiple SSPCs may be operated in a power distribution unit supplying power from a power source to various systems. In one form, the switching component may include any of various types of transistors, such as, for example, a MOSFET.

At block 904, the input current to the switching component is regulated and limited. In one form, it is contemplated that the current limiting control circuit may provide closed loop current feedback. The current limiting control circuit may include a current level sensor at an output of the switching component to allow comparison of an input current signal to a current signal from the output of the switching component. It is also contemplated that the current limiting control circuit may include other components to facilitate current feedback. At block 906, closed-loop current feedback is received from the switching component to compare to an input current signal.

At block 908, a dI/dt generator is provided regulating the amount of input current being supplied to the switching component to a predetermined increasing or decreasing profile. The dl/dt generator helps eliminate or reduce transient voltage spikes that may occur when the SSPC is turned on. At block 910, the dl/dt generator may be selectively enabled or disabled for the SSPC, depending on various factors such as, for example, the complexity of the load.

It should be understood that the process 900 may include certain steps in the process 900 (such as addressed above) but may include additional steps. Further, it should be understood that the steps set forth above need not be performed in the sequential order that they are presented, unless specifically indicated. For example, block 910 (enabling or disabling the dl/dt generator) may be performed before, or immediately after, block 902 (operating the SSPC). In other words, the dl/d generator may be either enabled or disabled before operation of the SSPC or at an earlier point in the process 900.

Further aspects of the disclosure are provided by the subject matter of the following clauses:
There is provided a system for controlling input current to a solid state power controller, the system including: a solid state power controller comprising a switching component and configured for a current input and a current output; a current limiting control circuit of the solid state power controller regulating and limiting input current to the switching component; and a dl/dt generator operatively coupled to the current limiting control circuit, the dl/dt generator being adjustable to set a current limit setpoint to regulate an amount of input current being supplied to the switching component to a predetermined increasing or decreasing profile, the dl/dt generator modifying the current limit set point and amount of input current over time in accordance with the predetermined increasing or decreasing profile.

The system of the preceding clause wherein the dl/dt generator is adjustable to regulate the amount of input current being supplied to the switching component to a constantly increasing rate, the dl/dt generator being adjustable between a first, low level setting allowing a low constant rate of increase in input current and a second, high level setting allowing a high rate of increase in input current.

The system of one or more of the preceding clauses wherein the predetermined increasing or decreasing profile comprises a stepwise change of current.

The system of one or more of the preceding clauses wherein the current limiting control circuit is operatively coupled to the switching component and configured to receive closed-loop current feedback from the switching component to compare to an input current signal.

The system of one or more of the preceding clauses wherein the switching component comprises a transistor and the dl/dt generator provides an increasing ramp of current over time at the first, low level setting, the transistor being turned on at a controlled and constant rate over time.

The system of one or more of the preceding clauses wherein the current limiting control circuit is operatively coupled to a gate or base of the transistor and to an output of the transistor, the current limiting control circuit configured to receive current feedback from the transistor.

The system of one or more of the preceding clauses wherein the current limiting control circuit comprises a current level sensor at an output of the switching component to allow comparison of an input current signal from the dl/dt generator to a current signal from the output of the switching component.

The system of one or more of the preceding clauses wherein the dl/dt generator is further adjustable to a plurality of settings of input current rates between the first, low level setting and the second, high level setting.

The system of one or more of the preceding clauses wherein the second, high level setting corresponds to an uncontrolled input current rate to the solid state power controller that would occur without the dl/dt generator in the system.

The system of one or more of the preceding clauses wherein the dI/dt generator includes: one or more capacitors and one or more resistors that define an RC circuit; or a microcontroller in communication with a digital to analog converter, the microcontroller configured to generate a increasing or decreasing current profile.

The system of one or more of the preceding clauses wherein the dl/dt generator is adjustable to regulate the amount of input current being supplied to the switching component to a constantly decreasing rate, the dl/dt generator being adjustable between a third, low level setting allowing a low constant rate of decrease in input current and a fourth, high level setting allowing a high rate of decrease in input current.

The system of one or more of the preceding clauses wherein the dI/dt generator provides a decreasing ramp of current over time at the third, low level setting, the switching component being turned off at a controlled and constant rate over time.

The system of one or more of the preceding clauses further including a microcontroller operatively coupled to the dl/dt generator, the microcontroller configured to transmit a switch open or close command to the solid state power controller.

There is further provided a method of for controlling input current to a solid state power controller, the method including: operating a solid state power controller comprising a switching component and having a current input and a current output; regulating and limiting, by a current limiting control circuit of the solid state power controller, input current to the switching component; and regulating, by a dI/dt generator operatively coupled to the current limiting control circuit, an amount of input current being supplied to the switching component to a predetermined increasing or decreasing profile, the dl/dt generator modifying the amount of input current over time in accordance with the predetermined increasing or decreasing profile.

The method of the preceding clause wherein the dl/dt generator is adjustable to regulate the amount of input current being supplied to the switching component to a constantly increasing rate, the dl/dt generator being adjustable between a first, low level setting allowing a low constant rate of increase in input current and a second, high level setting allowing a high rate of increase in input current.

The method of one or more of the preceding clauses wherein the current limiting control circuit receives closed-loop current feedback from the switching component to compare to an input current signal.

The method of one or more of the preceding clauses wherein the dI/dt generator provides an increasing ramp of current over time at the first, low level setting, the switching component being turned on at a controlled and constant rate over time.

The method of one or more of the preceding clauses wherein the dl/dt generator is adjustable to regulate the amount of input current being supplied to the switching component to a constantly decreasing rate, the dI/dt generator being adjustable between a third, low level setting allowing a low constant rate of decrease in input current and a fourth, high level setting allowing a high rate of decrease in input current.

The method of one or more of the preceding clauses wherein the dl/dt generator provides a decreasing ramp of current over time at the third, low level setting, the switching component being turned off at a controlled and constant rate over time.

There is provided a system for controlling input current to solid state power controllers in power distribution units, the system including: a power distribution unit comprising a plurality of solid state power controllers, each solid state power controller comprising a switching component and configured for a current input and a current output; at least one current limiting control circuit of at least one solid state power controller regulating and limiting input current to a corresponding switching component; and at least one dl/dt generator operatively coupled to the at least one current limiting control circuit, the at least one dl/dt generator being adjustable to set a current limit setpoint to regulate an amount of input current being supplied to the corresponding switching component to a predetermined increasing or decreasing profile, the at least one dl/dt generator modifying the current limit set point and amount of input current over time in accordance with the predetermined increasing or decreasing profile.

It will be understood that various changes in the details, materials, and arrangements of parts and components which have been herein described and illustrated to explain the nature of the disclosure may be made by those skilled in the art within the principle and scope of the appended claims. Furthermore, while various features have been described with regard to particular embodiments, it will be appreciated that features described for one embodiment also may be incorporated with the other described embodiments.

## Claims

1. A system (300) for controlling input current to a solid state power controller, the system comprising:
a solid state power controller (302) comprising a switching component (306) and configured for a current input and a current output;
a current limiting control circuit (308) of the solid state power controller (302) regulating and limiting input current to the switching component (306); and
a dl/dt generator (304) operatively coupled to the current limiting control circuit (308), the dl/dt generator (304) being adjustable to set a current limit setpoint to regulate an amount of input current being supplied to the switching component (306) to a predetermined increasing or decreasing profile, the dl/dt generator modifying the current limit set point and amount of input current over time in accordance with the predetermined increasing or decreasing profile.

2. The system (300) of claim 1, wherein the dl/dt generator (304) is further adjustable to regulate the amount of input current being supplied to the switching component (306) to a constantly increasing rate, the dl/dt generator (304) further being adjustable between a first, low level setting allowing a low constant rate of increase in input current and a second, high level setting allowing a high rate of increase in input current.

3. The system (300) of claims 1 or 2, wherein the predetermined increasing or decreasing profile comprises a stepwise change of current.

4. The system (300) of any of the preceding claims, wherein the current limiting control circuit (308) is operatively coupled to the switching component (306) and configured to receive closed-loop current feedback from the switching component (306) to compare to an input current signal.

5. The system (300) of any of the preceding claims, wherein the switching component (306) comprises a transistor and the dl/dt generator (304) provides an increasing ramp of current over time at the first, low level setting, the transistor being turned on at a controlled and constant rate over time.

6. The system (300) of claim 5, wherein the current limiting control circuit (308) is operatively coupled to a gate or base of the transistor and to an output of the transistor, the current limiting control circuit (308) configured to receive current feedback from the transistor.

7. The system (300) of any of the preceding claims, wherein the current limiting control circuit (308) comprises a current level sensor (311) at an output of the switching component (306) to allow comparison of an input current signal from the dI/dt generator (304) to a current signal from the output of the switching component (306).

8. The system (300) of any of the preceding claims, wherein the dl/dt generator (304) is further adjustable to a plurality of settings of input current rates between the first, low level setting and the second, high level setting.

9. The system (300) of any of the preceding claims, wherein the second, high level setting corresponds to an uncontrolled input current rate to the solid state power controller (302) without the dl/dt generator (304) in the system.

10. The system (400, 500, 600) of any of the preceding claims, wherein the dl/dt generator comprises:
one or more capacitors (416) and one or more resistors (414) that define an RC circuit; or
a microcontroller (520, 620) in communication with a digital to analog converter (522, 622), the microcontroller (520, 620) configured to generate an increasing or decreasing current profile.

11. The system (300) of any of the preceding claims, wherein the dl/dt generator (304) is further adjustable to regulate the amount of input current being supplied to the switching component (306) to a constantly decreasing rate, the dl/dt generator (304) being further adjustable between a third, low level setting allowing a low constant rate of decrease in input current and a fourth, high level setting allowing a high rate of decrease in input current.

12. The system (300) of claim 11, wherein the dI/dt generator (304) provides a decreasing ramp of current over time at the third, low level setting, the switching component (306) being turned off at a controlled and constant rate over time.

13. The system (300) of any of the preceding claims, further comprising a microcontroller (312) operatively coupled to the dl/dt generator (304), the microcontroller (312) configured to transmit a switch open or close command (313) to the solid state power controller (302).

14. A method (900) for controlling input current to a solid state power controller, the method comprising:
operating a solid state power controller (302) comprising a switching component (306) and having a current input and a current output;
regulating and limiting, by a current limiting control circuit (308) of the solid state power controller (302), input current to the switching component (306); and
regulating, by a dl/dt generator (304) operatively coupled to the current limiting control circuit (308), an amount of input current being supplied to the switching component (306) to a predetermined increasing or decreasing profile, the dl/dt generator modifying the amount of input current over time in accordance with the predetermined increasing or decreasing profile.

15. The method (900) of claim 14, wherein the dl/dt generator (304) is adjustable to regulate the amount of input current being supplied to the switching component (306) to a constantly increasing rate, the dl/dt generator (304) being adjustable between a first, low level setting allowing a low constant rate of increase in input current and a second, high level setting allowing a high rate of increase in input current.
